# EUROPEAN PATENT SPECIFICATION

(11) **EP 0 635 875 B1**
(45) Date of publication and mention of the grant of the patent: **02.01.1997**
(21) Application number: 93903315.5
(22) Date of filing: 05.02.1993
(51) Int. Cl.: H01L 21/22, H01L 21/31, H01L 21/00

(54) **APPARATUS FOR HEAT TREATMENT**
ANORDNUNG ZUR THERMISCHEN BEHANDLUNG.
APPAREIL DE TRAITEMENT THERMIQUE

(43) Date of publication of application: 25.01.1995
(73) Proprietor: ASM JAPAN K.K., Tokyo 206 (JP)
(72) Inventor: KYOGOKU, Mitsusuke, Tama-shi, Tokyo 206 (JP)
(74) Representative: de Bruijn, Leendert C.
(86) International application number: JP9300146
(87) International publication number: WO9418695

(56) References cited:
- JP-A- 1 251 610
- JP-A- 4 048 725
- JP-A-63 161 612
- JP-A-63 177 426
- US-A- 5 048 800
- US-A- 5 127 365
- GENICHI HORIKOSHI, Vacuum Technology, March 18, 1983 (18.03.83), Takuo Kanno, Zaidan Hojin Tokyo Daigaku Shuppankai, p. 49-51.

## Description

The present invention relates to a load locking thermal treatment apparatus comprising a reaction chamber, a heating system around said reaction chamber, a transfer system for moving a boat supporting workpieces into and out from said reaction chamber and a transfer system containing chamber insulating said transfer system from the atmosphere,
a seal flange driven by a mobile section of said transfer system and separating the transfer system containing chamber from the reaction chamber;
said seal flange being a double structure comprising of a flange section made of a high purity material such as quartz and the like and a flange section made of a metal material, such that the quartz flange and the reaction chamber are sealed through a sealant when the metal flange is positioned at the limit of its movement.

There are several types of vertical heat treatment apparatus in the art.

JP-A-63-161 612 discloses a vertical heat treatment apparatus in which a sealing flange comprising of a metallic plate and a SiC plate mounted thereon is lifted directly by an arm member of the transfer system for moving a boat supporting wafers in and out of a reation chamber and the reaction chamber is sealed by a sealing material provided on the SiC plate.

US-A-5 048 800 discloses a vertical heat treatment apparatus in which a sealing flange of a single structure is lifted directly by a shaft of a transfer system and a reaction chamber is hermetically sealed by a sealing material provided on the sealing flange.

US-A-5,127,365 discloses a vertical heat treatment apparatus in which a sealing flange of a single structure is lifted directly by a shaft of a transfer system and a reaction chamber is sealed directly by the sealing flange.

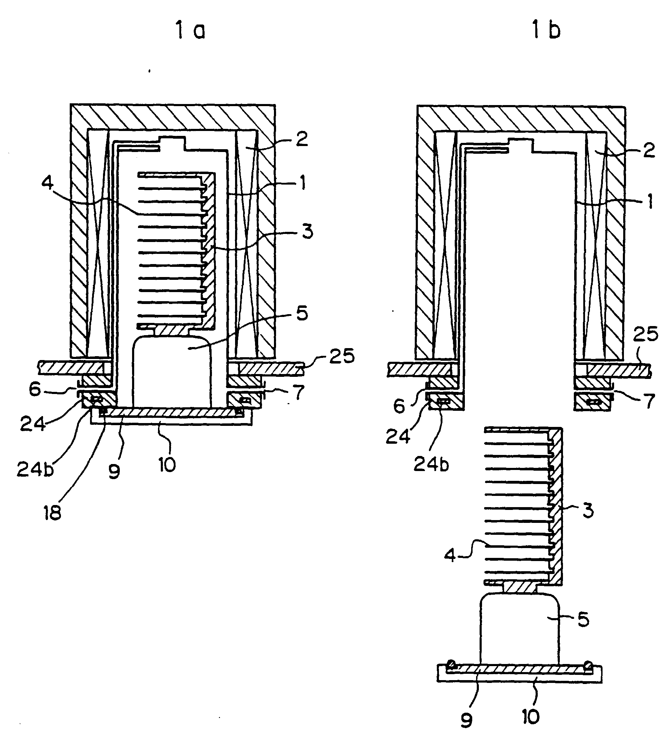

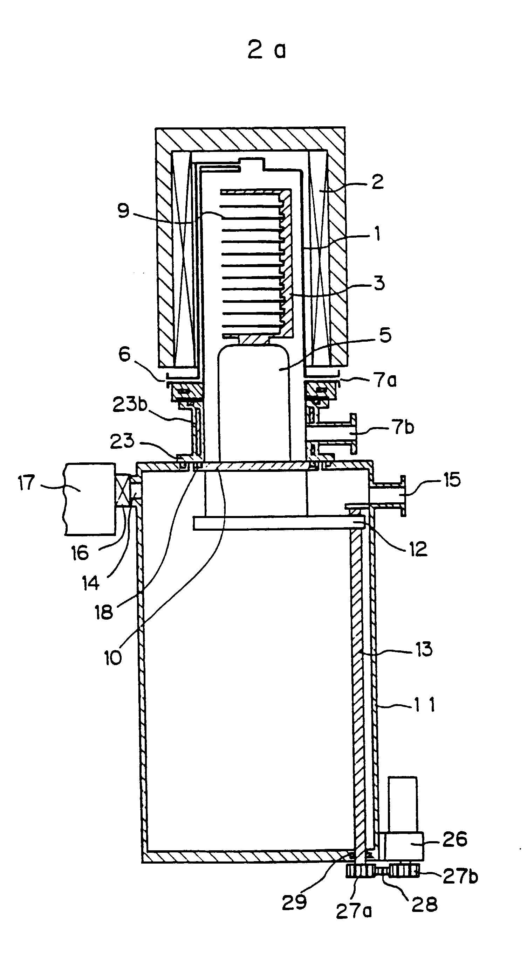

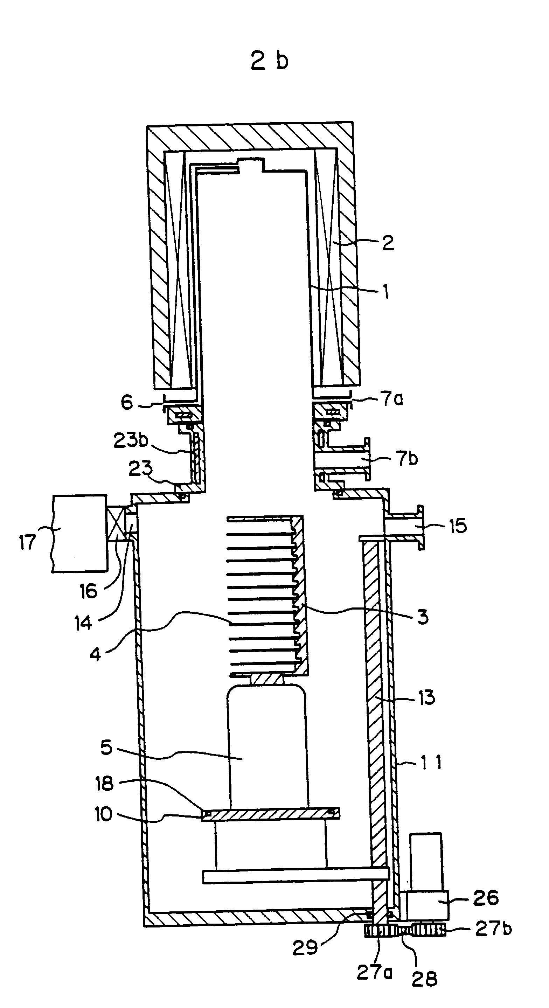

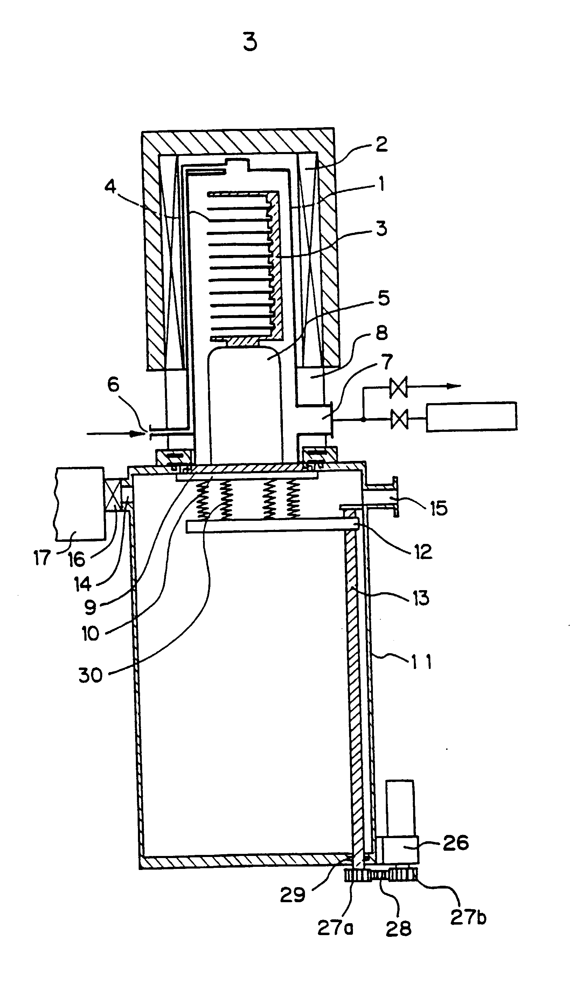

Figs.1a, 1b and Figs.2a, 2b show a conventional longitudinal type thermal treatment apparatus and a conventional load locking thermal treatment apparatus respectively.

A heater 2 is located around a reaction chamber 1 made of a high-purity material such as quartz and the like, and an open end of the reaction chamber 1 is sealed by a seal flange moved by a transfer system(not shown). A mobile section and the seal flange moved by the transfer system are connected by a spring member, so that it makes the sealing condition between the seal flange and the reaction chamber better. Because the pressure inside the reaction chamber during a process is about the same as an outer pressure, the spring member is required at least such resiliency that the spring member slightly pressurizes the seal flange onto the reaction chamber through a sealant. The seal flange is composed of a quartz flange 9 and a metal flange 10, and the quartz flange is only emerged inside the reaction chamber while the reaction chamber has been sealed. A gas introducing inlet 6 is provided in the reaction chamber 1, and communicating this with another closed end of the reaction chamber along a side wall outside the chamber, then a gas is introduced into the chamber through there. A gas vent 7 is provided about the open end of the reaction chamber, and the gas is vented through there. A boat table 5 and a boat 3 supporting, like a multi layer, a plurality of thermal treatment sections 4, are provided on the seal flange, and they are moved into and out from the reaction chamber by the transfer system.

When the boat has been moved out from the reaction chamber 1 (Fig.1b) by the transfer system, workpieces are set on the boat. The boat is moved into the reaction chamber by the transfer system, the flange is sealed and the reaction chamber is also sealed. An inactive gas, such as nitrogen gas, is introduced from the gas introducing inlet, and an atmospheric compound mixed into the chamber during moving the boat is purged. Achieving the workpiece to the predetermined temperature by the heater, then a gas for the predetermined process is introduced. Oxigen and the like is introduced for the dry oxidation process. Vapour and the like, which is produced by burning oxygen and hydrogen at an outer combustion device (not shown) provided before the introducing inlet 6, is introduced for the wet oxidation process, or oxyphosphorus chloride (POCl₃) and the like is introduced for the phosphorus dispersion process. The internal diameter of the introducing inlet is typically from about 10mm to about 20mm. The vent 7 is opened to the atmospheric environment and after an introduced gas contributes to the predetermined reaction, it is vented from the vent such that it is pressurized. The internal diameter of the vent is typically from about 10mm to about 20mm, and it is usually larger than the internal diameter of the introducing inlet. After completing the process, the introduction of a process gas is stopped, and after purging nitrogen gas and the like again, the boat is moved out from the reaction chamber by the transfer system.

Recently, according to the higher integration of a semiconductor device, in order to prevent an unpredictable oxidation caused by atmospheric compounds (oxygen, aqueous vapour and the like) and a residual process gas inside the reaction chamber after a process, the load locking thermal treatment apparatus has been developed. The examples are shown in Fig.2a and Fig.2b. A transfer system comprising a ball screw 13, a mobile section 12 and the like is set in a transfer system containing chamber 11 to seal to the atmosphere. The transfer system containing chamber 11 has a vent 15 to evacuate inside the chamber 11. Carring out a process at the atmospheric pressure, then a force is produced to open and to push the sealed flange by the pressure difference between the pressure inside the reaction chamber and the pressure inside the transfer system containing chamber. Thus, the sealed flange and the mobile section 12 are connected by a rigid member without the spring member and the pressure inside the transfer system containing chamber 11 is maintained about the atmospheric pressure by introducing the high purity nitrogen gas after evacuating, only during the process or all the time. The open section 14 is provided for moving a workpiece into or out from the transfer system containing chamber 11 and is connected with a front room 17 through a gate valve 16. A carrier system is contained to move the workpiece into or out from the boat from the open section in the front room. A metal manifold 23 having a vent 7b is provided by connecting with the reaction chamber to evacuate the inner section of the reaction chamber comprising a high purity material such as quartz, and this manifold has a cooling section 3b. After completing the process, evacuating the inner section to about 10⁻⁶ torr by the evacuating system connecting to the vent 7b, unloading the boat, then the workpiece is taken out.

The metal manifold has been provided to evacuate the inner section of the reaction chamber for the load locking thermal treatment apparatus which has been developed to embody the treatment of a higher integrated device,however, a heavy metal contamination is caused to the workpiece thereby and this causes to retrograde the performance of the apparatus. Because the oxidation process is carried out by a high temperature such as typically about 1000°C, its thermal radiation greatly affects. It may not be escaped that a metal contamination becomes to be larger than a metal contamination caused by an apparatus whose entire surface inside the reaction chamber is quartz such as a conventional oxidation diffusion apparatus, even if a cooling section is provided. Additionally, if over cooling is done, then vapour and the like will be condensated with dews on the surface inside the manifold at the wet oxidation, and it will exert further serious bad influences such as the metal corrosion and the like. Also, the thermal diffusion from the lower section of the heater becomes larger by the cooling, and it then causes the average thermal characteristic of the heater to be worse.

If the transfer system containing chamber is filled by high purity nitrogen gas after evacuating, the degree of cleanliness of the environment in the apparatus has a limit depended on the degrees of cleanliness of a supplied nitrogen gas and a gas supplying system. In order to respond to the request to a device of the further degree of integration, the pressure in the transfer system containing chamber is required to maintain in the high vacuum environment below 10⁻⁷ torr for further reducing the densities of residual oxygen, vapour and the like. If the environment of the transfer system containing chamber becomes the state of the atmospheric pressure by nitrogen gas during the process below the atmospheric pressure and the evacuation is done after completing the process, the throughput by the apparatus decreases and the cost of the supplied high purity nitrogen gas increases. If the mobile section and the seal flange are connected by a rigid member to each other, the accuracy of the stop position of the mobile section and the degree of the parallelization between the seal flange and the interfacing surface should be strictly monitored, and thus the manufacturing cost can increase and the great skill is also required to incorporate again after the reaction chamber maintenance.

### Disclosure of the invention

The invention is related to an apparatus according to the features of the subject-matter of claim 1.

A vent is provided in a reaction chamber to evacuate its inner section. A seal flange has a doubled structure of a quartz flange and a metal flange and seales through a sealant between the reaction chamber and the quartz flange.

A spring member connects between the seal flange and a mobile section, and after moving the seal flange to a sealing position, the mobile section is moved, then stopped and held so that the magnitude of a resiliency of the spring member produced by further moving the mobile section is larger than the magnitude of a force acting from the reaction chamber to the seal flange when a pressure in a transfer system containing chamber is in vacuum and a pressure in the reaction chamber is at the atmospheric pressure.

### Brief description of dwawings

Fig.1a shows a conventional thermal treatment apparatus.

Fig.1b shows a conventional thermal treatment apparatus moved out the boat table from a reaction chamber.

Fig.2a shows a conventional load locking thermal treatment apparatus.

Fig.2b shows a conventional load locking thermal treatment apparatus moved out a boat table from a reaction chamber.

Fig.3 shows an apparatus according to the present invention.

Fig.4a shows a partial enlarged view of the apparatus shown in Fig.3.

Fig. 4b shows a partial enlarged view of the apparatus shown in Fig.3.

Fig.4c shows a partial enlarged view of another embodiment.

### Prefered embodiment of the present invention

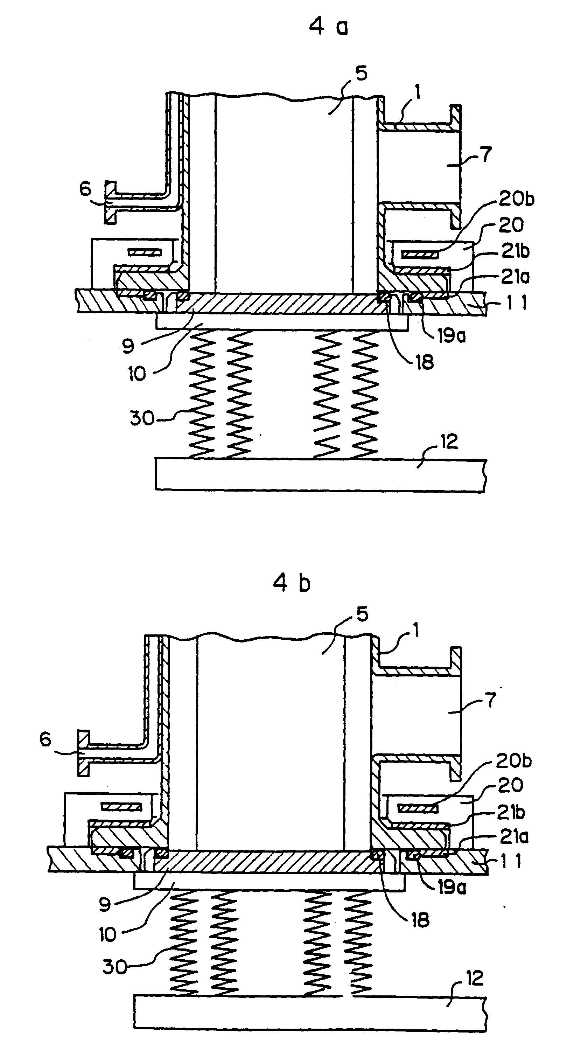

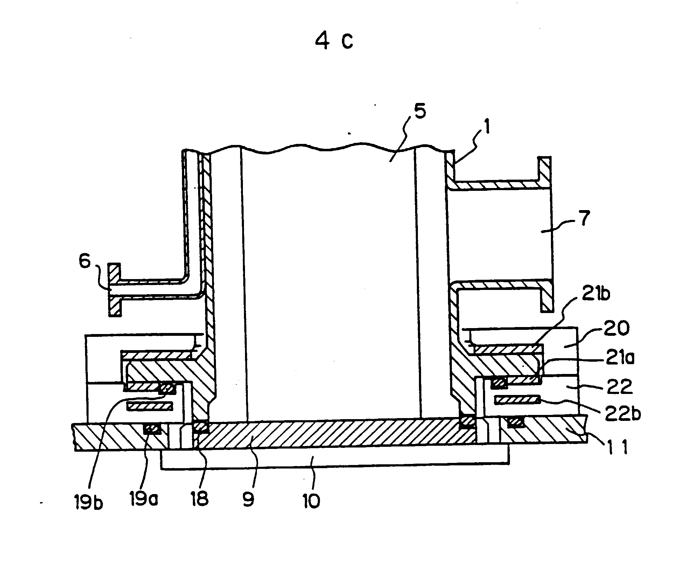

Fig.3 shows one embodiment of the present invention. Fig.4a is a partial enlarged view of Fig.3.

A vent 7 provided in a reaction chamber 1 to evacuate inside the chamber. The internal diameter of the vent should be at least over about 50mm to evacuate inside the reaction chamber in short period. In the present invention, the internal diameter of the reaction chamber and the vent are 240 mm and 100mm respectively, but it is no problem in the stiffness and the like if it is structured by quartz. A vent line at the process in the atmospheric pressure may be provided and may be branched before the vent 7. By mounting a heat insulator 8 around the reaction chamber before and after the vent 7, heat escaped from this section is prevented and the average thermal characteristic of the heating unit is improved. The temperature on the wall inside the reaction chamber is kept at such a temperature that does not condensate vapour with dews in the inner section during the wet oxidation process.

The quartz flange 9 placing a boat 3 and a boat table 5 is set on the metal flange 10 and then moved by the transfer system. When the boat 3 is moved to a predetermined position in the reaction chambe 1, the shoulder section of metal flange touches to the shoulder section 11 of the transfer system containing chamber and it is then unable to move any more. At this time, there is a small annulus between the quartz flange and the reaction chamber, and it is sealed by a sealant 18 comprising of fluoro rubber and the like. Thus, the quartz may not be broken because each quartz does not collide and an excess force does not apply on the parts of quartz. Supposing that the dimention of mobile sectio 12 and the metal flange 10 is represented by ┌A┘ at this time, the mobile section 12 is further moved and becomes the dimension of ┌B┘. As shown in Fig.4b, by the resiliency of the spring member i.e. a magnitude of multiplying the spring coefficient of a spring member 30 by the amount of compression ┌A-B┘, the metal flange 10 is pressurized on the shoulder section of the transfer system containing chamber 11. The process in the atmospheric pressure is carried out by keeping the transfer system containing chamber in vacuum with this state. At this time, a magnitude of a force which is multiplied the effective area of the internal diameter of the sealant 18 by the pressure difference between two chambers excerts from the transfer system containing chamber to the seal flange. The amount of the compression ┌A-B┘ and the spring coefficient of the spring has been determined such that the spring resiliency is larger than the magnitude of the force. Fven if excerting the force by the pressure difference downwards, the quartz flange cannot be broken because the metal flange 10 employs to the quartz flange as reinforced. The metal flange 10 can not be moved downwards because a force above the magnitude of a force employing from the transfer system containing chamber is excerted upwards by the spring member. Thus, the process gas can not leak to the transfer system containing chamber during the process. A flange section of the end section of the reaction chamber 1 is mounted through a sealant 19a and a cushioning material 21a on the mobile system containing chamber 11 and is fixed through the cushoning material 21b by a fixed flange 20 having a cooling section 20b. The cooling section may be provided in the transfer system containing chamber side.

Fig.4c shows a partial enlarged view of another embodiment. The reaction chamber 1 is defined as a tube shape up to the lower side of the flange section, is expanded the internal diameter about its end section and is sealed at the end section. By this, heat energy as a beam propagating in the transparent inner section of the quartz is reflected and a heat influence to the sealant 18 can be reduced. The flange section of the reaction chambe 1 is fixed on a flange 22 having means for cooling and the flange 2 is fixed on the transfer system containing chamber 11.

## Claims

1. A load locking thermal treatment apparatus comprising a reaction chamber (1), a heating system (2) around said reaction chamber, a transfer system for moving a boat supporting workpieces into and out from said reaction chamber and a transfer system containing chamber (11) insulating said transfer system from the atmosphere,
a seal flange (9, 10) driven by a mobile section of said transfer system and separating the transfer system containing chamber (11) from the reaction chamber (1);
said seal flange being a double structure comprising of a flange section (9) made of a high purity material such as quartz and the like and a flange section (10) made of a metal material, such that the quartz flange and the reaction chamber are sealed through a sealant when the metal flange is positioned at the limit of its movement
characterized in that
said seal flange and said mobile section are connected by a spring member, the magnitude of a resiliency of said spring member, which is produced by moving the mobile section after moving the seal flange to the movable limit, being greater than the magnitude of a force acting from said reaction chamber to said seal flange when the process pressure in the reaction chamber is greater than the pressure in said transfer system containing chamber during the process, so that the mobile section can be stopped and held at the position when the pressure in said transfer system containing chamber is in vacuum and the pressure in the reaction chamber is at the atmospheric pressure during the process.

2. A heat treatment apparatus according to claim 1 wherein a vent is provided on a wall of said reaction chamber in order to evacuate inside said reaction chamber.

3. A heat treatment apparatus according to claim 2 wherein said vent is provided between said heater and said transfer system containing chamber.

4. A heat treatment apparatus according to claim 2 or claim 3 wherein an internal diameter of said vent is more than 50mm.

5. A heat treatment apparatus accoding to claim 2 or claim 3 having an evacuating system evacuating inside said reaction chamber, said evacuating system controlling a chamber pressure in a range of 10 torr to 10⁻³torr.

## Patentansprüche

1. Lastsschleusende Vorrichtung zur thermischen Behandlung mit einer Reaktionskammer (1), einem Heizsystem (2) um die Reaktionskammer, einem Transportsystem zum Bewegen eines Schiffchens, das Werkstücke trägt, in die Reaktionskammer hinein und aus dieser heraus und einer das Transportsystem enthaltenden Kammer (11), die das Transportsystem gegen die Atmosphäre isoliert,
einem Dichtflansch (9, 10), der durch einen beweglichen Bereich des Transportsystems betätigt wird und die Transportsystem enthaltende Kammer (11) von der Reaktionskammer (1) trennt;
wobei der Dichtflansch einen doppelten Aufbau hat, bestehend aus einem Flanschbereich (9) aus einem hochreiner Metall, z. B. Quarz u. dgl., und einen Flanschbereich (10) aus einem Metallmaterial, so daß der Quarzflansch und die Reaktionskammer mittels eines Dichtungsmittels abgedichtet werden, wenn der Metallflansch an der Begrenzung seiner Bewegung positioniert wird,
dadurch gekennzeichnet, daß der Dichtflansch und der bewegliche Bereich durch ein Federteil verbunden sind, wobei die Größe einer Elastizität des Federteils, die durch Bewegen des beweglichen Bereichs erzeugt wird, nachdem der Dichtflansch bis zur Bewegungsbegrenzung bewegt worden ist, größer ist als die Größe einer Kraft, die von der Reaktionskammer auf den Dichtflansch wirkt, wenn der Prozeßdruck während des Prozesses in der Reaktionskammer größer ist als der Druck in der das Transportsystem enthaltenden Kammer, so daß der bewegliche Bereich angehalten und in der Position gehalten werden kann, wenn der Druck in der das Transportsystem enthaltenden Kammer einem Vakuum entspricht und der Druck in der Reaktionskammer dem atmosphärischen Druck während des Prozesses entspricht.

2. Vorrichtung zur thermischen Behandlung nach Anspruch 1, wobei eine Entlüftungseinrichtung an einer Wand der Reaktionskammer vorgesehen ist, um das Innere der Reaktionskammer zu entlüften.

3. Vorrichtung zur thermischen Behandlung nach Anspruch 2, wobei die Entlüftungseinrichtung zwischen dem Heizer und der das Transportsystem enthaltenden Kammer vorgesehen ist.

4. Vorrichtung zur thermischen Behandlung nach Anspruch 2 oder 3, wobei ein Innendurchmesser der Entlüftungseinrichtung größer als 50 mm ist.

5. Vorrichtung zur thermischen Behandlung nach Anspruch 2 oder 3 mit einem Evakuierungssystem, das das Innere der Reaktionskammer evakuiert, wobei das Evakuierungssystem einen Kammerdruck in einem Bereich von 10 Torr bis 10⁻³ Torr steuert.

## Revendications

1. Un appareil de traitement thermique à éclusage de charge, comprenant une chambre de réaction (1), un système de chauffage (2) installé autour de ladite chambre de réaction, un système de transfert destiné à déplacer un mobile supportant des pièces façonnées dans et hors de ladite chambre de réaction et une chambre (11) contenant le système de transfert, et isolant ledit système de transfert de l'atmosphère,
une bride d'étanchéité (9, 10) entraînée par une section mobile dudit système de transfert et séparant la chambre (11) contenant le système de transfert vis à vis de la chambre de réaction (1);
ladite bride d'étanchéité étant une structure double constituée d'une section bride (9), constituée d'un matériau à pureté élevée tel que du quartz et analogue, et d'une section bride (10) réalisée en un matériau métallique, de manière que la bride en quartz et la chambre de réaction soient isolées de façon étanche par l'intermédiaire d'un produit d'étanchéité, lorsque la bride métallique est positionnée sur la limite de son déplacement, caractérisé en ce que ladite bride d'étanchéité et ladite section mobile sont reliées par un organe de ressort, la valeur de l'élasticité dudit organe ressort, qui est produite par déplacement de la section mobile après déplacement de la bride d'étanchéité à la limite de déplacement, étant supérieure à la valeur d'une force agissant depuis ladite chambre de réaction sur ladite bride d'étanchéité lorsque la pression du processus régnant dans la chambre de réaction est supérieure à la pression régnant dans ladite chambre contenant le système de transfert durant le processus, de manière que la section mobile puisse être stoppée et maintenue à la position prise lorsque la pression régnant dans ladite chambre contenant le système de transfert correspond à un vide et que la pression régnant dans la chambre de réaction est la pression atmosphérique, pendant la durée du processus.

2. Un appareil de traitement thermique selon la revendication 1, dans lequel un évent est prévu sur une paroi de ladite chambre de réaction de manière à évacuer l'intérieur de ladite chambre de réaction.

3. Un appareil de traitement thermique selon la revendication 2, dans lequel ledit évent est prévu entre ledit système de chauffage et ladite chambre contenant le système de transfert.

4. Un appareil de traitement thermique selon la revendication 2 ou la revendication 3, dans lequel le diamètre interne dudit évent est supérieur à 50 mm.

5. Un appareil de traitement thermique selon la revendication 2 ou la revendication 3, ayant un système d'évacuation assurant l'évacuation de l'intérieur de ladite chambre de réaction, ledit système d'évacuation commandant la pression de la chambre à une valeur comprise dans la plage allant de 10 Torr à 10⁻³ Torr.
